(19) Europäisches Patentamt
European Patent Office
Office européen des brevets

(11) **EP 4 246 590 A2**

(12) **EUROPEAN PATENT APPLICATION**

(43) Date of publication:
**20.09.2023   Bulletin 2023/38**

(21) Application number: **23161820.8**

(22) Date of filing: **14.03.2023**

(51) International Patent Classification (IPC):
*H01L 29/12* (2006.01)    *H01L 29/36* (2006.01)
*H01L 29/423* (2006.01)    *H01L 29/76* (2006.01)
*B82Y 10/00* (2011.01)

(52) Cooperative Patent Classification (CPC):
**H01L 29/7613; H01L 29/127; H01L 29/36;
H01L 29/423; H01L 29/66977; B82Y 10/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.03.2022   AU 2022900615
02.06.2022   AU 2022203834**

(71) Applicant: **Silicon Quantum Computing Pty Ltd
Kensington, NSW 2052 (AU)**

(72) Inventors:
• **KRANZ, Ludwik**
  **Kensington, New South Wales, 2052 (AU)**
• **SIMMONS, Michelle Yvonne**
  **Kensington, New South Wales, 2052 (AU)**
• **RAHMAN, Rajib**
  **Kensington, New South Wales, 2052 (AU)**

(74) Representative: **Grünecker Patent- und
Rechtsanwälte
PartG mbB
Leopoldstraße 4
80802 München (DE)**

(54) **QUANTUM PROCESSING SYSTEMS AND METHODS**

(57)   A quantum processing element is disclosed. The qubit includes a semiconductor substrate (204), a dielectric material (205) forming an interface with the semiconductor substrate, a confinement gate (211) and antenna (214) on the dielectric material, and a donor molecule (208a, 208b) embedded in the semiconductor. The donor molecule includes a plurality of dopant dots (210a, 210b, 210c) embedded in the semiconductor, each dopant dot includes one or more dopant atoms, and one or more electrons/holes confined to the dopant dots. A distance between the dopant dots is between 3 and 9 nanometres.

*Fig. 2*

EP 4 246 590 A2

# Description

## CROSS REFERENCE

This application claims priority from Australian provisional patent application number 2022900615 filed on 14 March 2022 and Australian patent application number 2022203834 filed on 02 June 2022, the entire content of which are incorporated herein in their entirety.

## TECHNICAL FIELD

Aspects of the present disclosure are directed to systems and methods for fabricating quantum processing systems using dopant atoms in semiconductors.

## BACKGROUND

Universal quantum computing is a potentially revolutionary technology that could be applied in certain domains to solve problems that are intractable when running the currently known best classical algorithms on state-of-the-art classical computers. Examples of domains in which universal quantum computers are known to provide an advantage include classes of optimization problems, advanced chemistry simulations, and finding prime factors of large numbers, which would defeat the most common classical encryption protocols. For some of these applications, such as finding prime factors of large numbers, quantum computers should be exponentially faster than their classical counterparts. Quantum computing may also be useful in certain machine learning applications.

Quantum computers use the properties of quantum physics to store data and perform operations required for computation. In a quantum computer, the basic unit of memory is a quantum bit or a qubit. Engineering qubits in quantum processing elements is integral to building a universal quantum computer. To date, a number of different structures, materials, and architectures have been proposed to implement quantum processing systems and fabricate their basic information units (or quantum bits).

## SUMMARY

According to a first aspect of the present disclosure, there is provided a quantum processing element comprising: a semiconductor substrate; a dielectric material forming an interface with the semiconductor substrate; and a donor molecule comprising a plurality of dopant dots embedded in the semiconductor, each dopant dot comprising one or more dopant atoms and one or more electrons/holes confined to the dopant dots, where a distance between the dopant dots is between 3 and 9 nanometres.

In some embodiments, the quantum processing element including two dopant dots, where a first dopant dot includes two dopant atoms and a second dopant dot includes one dopant atom. The dopant atoms may be phosphorus atoms.

In some embodiments, quantum information is encoded in a spin of an unpaired electron/hole of the one or more electrons/holes. The spin of the unpaired electron/hole is controlled with an external magnetic and/or electric field. In some examples, the electric field may be applied at a predetermined angle to a central axis of the dopant dots.

In some other embodiments, spin of an electron/hole confined to one of the dopant dots is strongly exchange coupled to an electron/hole confined to a neighbouring dopant dot of the one or more dopant dots. In some examples, due to the strong exchange coupling, the spins of the exchange coupled electrons/holes may form magnetic singlet states across the donor molecule.

In yet other embodiments, an external magnetic field is applied to separate energy levels of at least one spin of the one or more electrons/holes, and a resultant Zeeman splitting is smaller than an exchange coupling between the dopant dots.

According to a second aspect of the present disclosure, there is provided a method of fabricating an engineered quantum processing element, the method comprising: exposing a semiconductor substrate to atomic hydrogen to form a monolayer of hydrogen and passivating a surface of the semiconductor substrate; selectively desorbing hydrogen atoms from the passivated surface by application of appropriate voltages and tunnelling currents to an STM tip, and forming a plurality of patches in the hydrogen monolayer, wherein a distance between adjacent patches is between 3 and 9 nanometres; and incorporating one or more donor atoms in each of the plurality of patches in the hydrogen monolayer, to form a donor molecule.

According to a third aspect of the present disclosure, there is provided a quantum processing system, comprising a semiconductor substrate; a dielectric material forming an interface with the semiconductor substrate; and a plurality of donor molecules embedded in a plane in the semiconductor substrate. Each donor molecule includes a plurality of dopant dots, each dopant dot includes one or more dopant atoms, and one or more electrons/holes confined to the dopant dots. A distance between adjacent dopant dots in a donor molecule is between 3 and 9 nanometres.

In some embodiments, the method further includes desorbing the hydrogen monolayer; overgrowing a surface with a layer of the semiconductor; growing a dielectric layer above the layer of the semiconductor; and depositing one or more gates above positions of the donor atoms.

In some examples, the method further includes applying a voltage to the one or more gates to cause one or more electrons to be confined in the donor molecule.

A first patch and a second patch may be formed in the hydrogen monolayer during the fabrication method, a single donor atom may be incorporated in the first patch, and two donor atoms may be incorporated in the second patch to form the donor molecule.

In some embodiments, five electrons may be confined to the donor molecule.

In yet other embodiments, the sizes of the plurality of patches is based on a number of donor atoms to be incorporated in corresponding patches. The donor atoms may be phosphorus atoms. The semiconductor substrate may be silicon28.

## BRIEF DESCRIPTION OF DRAWINGS

Features and advantages of the present invention will become apparent from the following description of embodiments thereof, by way of example only, with reference to the accompanying drawings, in which:

Fig. 1A is a chart showing the relationship between exchange coupling $J$ between two donors in silicon and the inter-donor separation distance d between the donor atoms.

Fig. 1B is a schematic showing different coupling regimes for donor qubits based on the inter-donor separation distance.

Fig. 2 is a schematic illustrating an example donor molecule quantum processing element as disclosed herein.

Figs. 3A-3B outlines the individual processing steps (steps a-k) for fabricating donor molecules according to aspects of the present disclosure.

Fig. 4A shows an STM image of a quantum processing device according to aspects of the present disclosure.

Fig. 4B shows a zoomed-in portion of the STM Image of Fig. 4A, in particular a zoomed in view of a donor molecule of the quantum processing device of Fig. 4A.

Fig. 4C shows a zoomed-in portion of the STM image of Fig. 4B, in particular, a zoomed in view of a donor dot of the donor molecule of Fig. 4B.

Fig. 4D is a schematic showing an arrangement of surface features in the device 200 with respect to the silicon lattice before incorporation of phosphorous atoms.

Fig. 4E is a schematic showing an arrangement of surface features in the device 200 with respect to the silicon lattice after incorporation of phosphorous atoms.

Fig. 5A is a charge stability diagram of the quantum processing device of Fig. 4A.

Fig. 5B is a zoomed-in portion of the stability diagram of Fig. 5A around a first charge transition of the donor molecule.

Fig. 5C is a schematic showing $D^-$spin readout at a first charge transition to determine the spin parity shown in Fig. 5B.

Fig. 5D is a schematic showing $D^+$spin readout at a first charge transition to determine the spin parity shown in Fig. 5B.

Fig. 5E is a schematic of the charge stability diagram of Fig. 5A showing odd and even spin pairing for a weakly coupled pair of donor dots.

Fig. 5F is a schematic of the charge stability diagram of Fig. 5A showing odd and even spin pairing for a strongly coupled pair of donor dots.

Fig. 5G is a charge stability diagram showing charge transitions for $R_\alpha$ and $R_\beta$ and a measured electron parity at each transition.

Fig. 6A shows a four-stage pulse sequence used to control the spin of the donor molecule.

Fig. 6B shows a readout trace for the four-stage pulse sequence of Fig. 6A.

Fig. 7A is a schematic showing a charge stability diagram of a 1P-2P donor molecule.

Fig. 7B is a schematic showing locations of three P atoms within the 1P-2P molecule, together with computed wavefunctions for 1, 3, and 5 electrons bound to the 1P-2P molecule.

Fig. 7C shows the theoretical and experimental ESR spectra of the first, third and fifth electrons bound to a 1P-2P donor molecule.

## DETAILED DESCRIPTION

One type of quantum computing system is based on spin states of individual qubits where the qubits are electron and/or nuclear spins localized inside a semiconductor quantum chip. These electron and/or nuclear spins are confined either in gate-defined quantum dots or on donor atoms that are positioned in a semiconductor substrate.

Donors in silicon offer many benefits compared to gate-defined quantum dots. Firstly, confinement of an electron spin qubit arises naturally from the presence of a donor potential, so that heterostructure engineering and surface confinement gates are not necessary to isolate single electrons. Secondly, atom qubits allow for electron spin qubits to be hosted within a crystalline environment, which has been shown to reduce the electrical noise coupling from the environment to qubits. Furthermore, the confinement potential of donors is much stronger than in the case of gate-defined quantum dots, resulting in long qubit life-times (approximately 30 seconds), and high-fidelity fast readout of the qubits.

To date, two main approaches to fabricating donor qubits in silicon have been pursued: donors can either be implanted into the silicon crystal lattice via ion implantation techniques or placed with atomic precision using hydrogen lithography scanning tunnelling microscopy (STM). The latter approach allows for atomic engineering of the confinement potential by placing either a single P atom or multiple P atoms in close proximity ($\leq$ 3 nm) to form multi-donor dots. It has been shown that these multi-donor dots offer several benefits including tunability of the exchange interaction and improved addressability of individual qubits leading to lower gate error rates. Moreover, the confinement potential of multi-donor dots is stronger compared to single donors, yielding longer electron spin life-times (~30 s) and ability to load multiple electrons (<5) onto a single multi-donor dot.

Aspects of the present disclosure present a novel type of electron-donor system in a semiconductor substrate. As referred to herein, the presently disclosed system is called a donor molecule system. The donor molecule system includes n separate donor sites, each including at least one donor atom. For the system to be considered a donor molecule, separation between the n donor dot sites is within a specific range - approximately 3-9 nm. The lower bound of this range in defined by the Bohr radius of a confined electron - i.e., the separation between any two donor dot sites must be larger than the electron Bohr radius. Otherwise, the created system (between those two donor sites) would be considered a single donor site. The upper bound of this range is defined by the exchange coupling between the electrons loaded onto these two separate donor sites, i.e., the exchange coupling between the electrons loaded onto the two donor dot sites must be larger than the Zeeman energy of the individual electrons). Otherwise, the created system would be considered as two separate electron-donor systems.

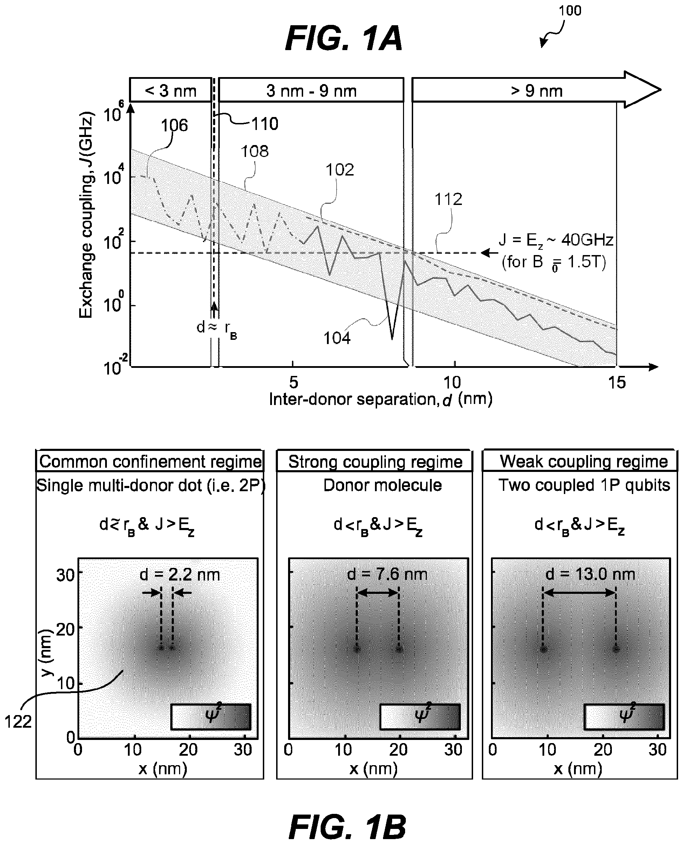

Fig 1 is a schematic 100 illustrating the definition of the molecular regime for donor qubits. In particular, Fig. 1A is a chart showing the exchange coupling $J$ between two donors in silicon on the y-axis and the inter-donor separation distance d between the donor atoms on the x-axis. The figure also shows the exchange coupling $J$ when the donors are separated along the [100], [110] and [110] crystallographic axes (102,104,106). The shaded area 108 is a guide to highlight the overall exchange coupling dependence. The vertical line 110 indicates the approximate Bohr radius for donors is silicon, which is typically around $r_B \approx 2 - 3$ nm. The horizontal line 112 indicates a Zeeman energy ($E_Z$) of 40 GHz, which corresponds to the energy splitting of electron spin qubits that are typically operated at magnetic fields of $B_0 \sim 1.5$ T.

Fig. 1B shows three different coupling regimes depending on the inter-donor separation d when using donors to form electron spin qubits. The first regime, also called the common confinement regime, corresponds to small inter-donor separations, where the distance between the dots is less than the Bohr radius ($d \lesssim r_B$). In this regime, donors collectively form a strong confinement potential (as seen in Fig. 1A). It has been demonstrated that this regime benefits from long relaxation times due to the smaller wavefunction of electron confined to such multi-donor dots.

The third regime, also called the weak coupling regime, occurs when inter-donor separations are greater than Bohr radium, ($d > r_B$) and the exchange coupling $J$ is less than the Zeeman energy $E_Z$. In this regime, the electron wavefunctions of the two dots are spatially separated and have a relatively small overlap. This relatively small overlap between electron wavefunctions, gives rise to the exchange coupling $J$ being smaller than the Zeeman energy $E_Z$ of the individual electron spins. Consequently, the $|\downarrow\rangle|\downarrow\rangle$ state is the lowest energy state in this regime.

Finally, in the intermediate regime, also called the strong coupling regime, the inter-donor separations are greater than the Bohr radius but the exchange coupling $J$ is greater than the Zeeman energy $E_Z$. In this regime, the interdot distances are 3nm < $d$ < 9 nm. This regime 140 includes two separated confinement potentials. As a result, it is energetically favourable for two electron spins to form a singlet state between the dots, such that the singlet $|S\rangle = \frac{1}{\sqrt{2}}(|\downarrow\uparrow\rangle - |\uparrow\downarrow\rangle)$ is the ground state. This gives rise to a unique molecular regime where, due to the strong exchange interaction, electrons are effectively shared between the spatially separate donor sites.

It is this intermediate regime 140 that defines a donor molecule according to aspects of the present disclosure.

### Example donor molecule

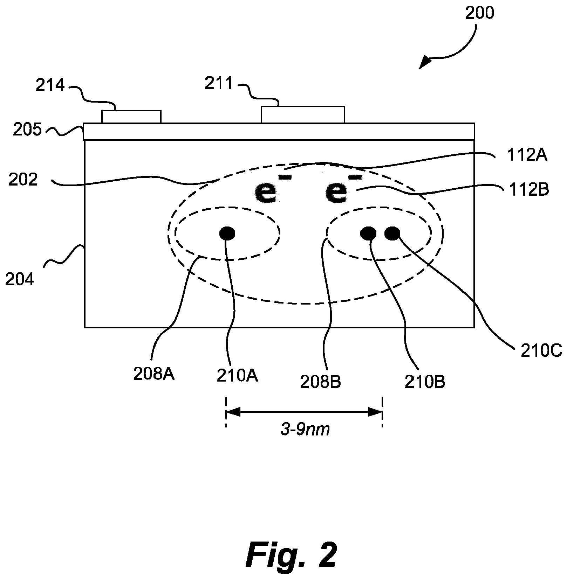

Fig. 2 illustrates an example donor molecule quantum processing device 200 as disclosed herein. The device 200 includes a donor molecule 202 located in a semiconductor substrate 204. In this example, the semiconductor substrate 204 is [28]Silicon. The silicon substrate 204 is topped by a barrier material/dielectric 205 such as silicon dioxide.

The donor molecule 202 includes a plurality of dopant dots embedded in the semiconductor substrate 204. In this example, the donor molecule 202 includes two dopant dots, 208A, and 208B. Each dopant dot 208 includes one or more dopant atoms 110. In this example, the left dopant dot 208A has one donor atom 210A and the right dopant dot 208B has two donor atoms 210B and 210C. The distance between the dopant dot sites 108 is between 3-9 nanometers. In one example, the distance is 8 nanometers.

Further, one or more gates (e.g., gate 211) and an antenna 214 may be located on the dielectric 205 in a region above the quantum dot 201. Voltages may be applied to gate 211 to confine one or more electrons 212 in the donor molecule 202. These electrons 212 may be confined to the dopant dots. In this example, two electrons 212 are confined in the donor molecule 202. The 1P-2P molecule 202 shown in Fig. 2, can collectively bind up to five electrons. The antenna 214 may be used to generate an oscillating magnetic field during operation.

In certain embodiments, the donor dots 208 are placed in the silicon substrate 204 with atomic-scale precision using scanning tunnelling lithography techniques. In particular, during fabrication, two separate lithographic patches can be defined in the semiconductor substrate that are separated by 3-9 nanometers. A predetermined number of donor atoms 210 can then be placed in the two lithographic patches. In some examples, the donor dots 208 may be located approximately 50 nm below the surface 206. In the example shown in Fig. 2, 1 donor atom is placed in the first lithographic patch and 2 donor atoms are placed in the second lithographic patch. By having two separate donor dot sites, the donor molecule system of the present disclosure creates a highly anisotropic electron confinement.

Despite the relatively large separation, the electron spins in the donor dots 208 form singlet states across both donor sites as the exchange energy $J$ exceeds the electron Zeeman splitting.

The device 200 as shown in Fig. 2 offers a number of benefits for quantum computing applications. For instance, this system demonstrates coherent control over the 1e and 5e states, with a Rabi frequency of ~ 1.8 MHz, coherence times of $T^{Hahn}_2$ ~ 300 microseconds, and readout fidelities exceeding 91%. Further, these molecular qubits can be operated at different electron occupancies without hampering the coherence times. Further still, donor molecules as disclosed herein can be used for precise shaping of confinement potentials by controlling the relative positions of donor dots within the molecule, as well as the number of donors in each dot. This ability to shape electron wavefunctions has many advantages. For instance, by shaping the electron wavefunction, the individual hyperfine couplings can be controlled, which can be used for addressing individual nuclear and electron spins in architectures that contain multiple molecules. Further yet, by shaping the electron wavefunction, the confinement potential can be controlled, which determines the properties of electron spin qubits - such as relaxation time and charging energy. This means that the molecules 202 can be optimised at atomic scale to design electron spin qubits with desired properties.

*Example Fabrication process for engineering quantum processing device*

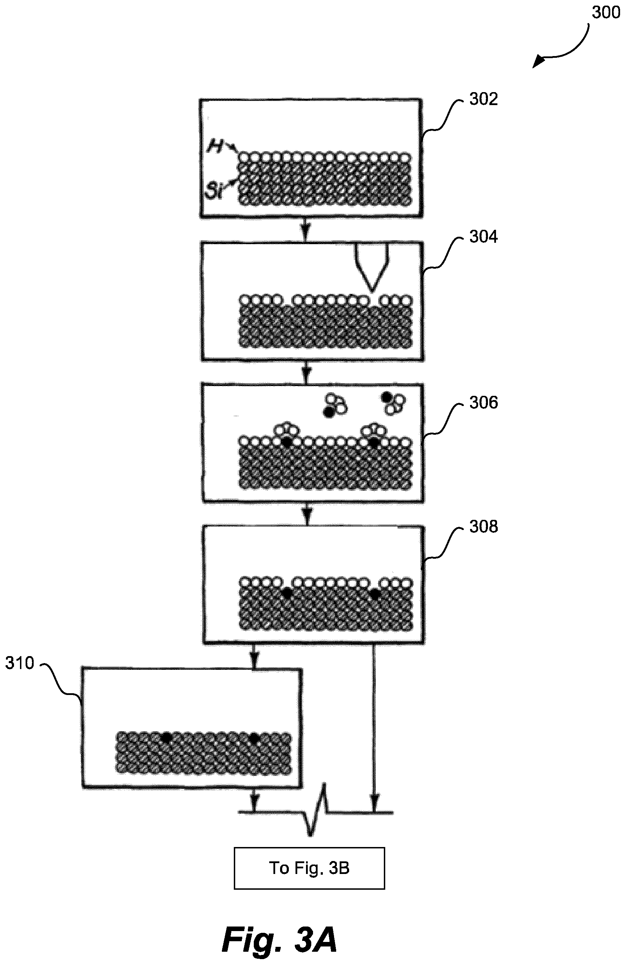

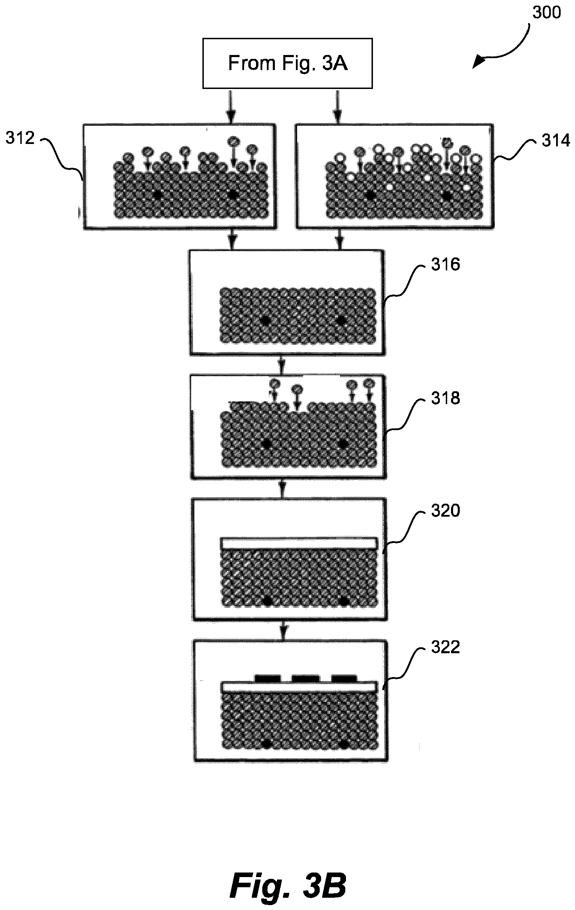

Fig. 3 outlines the individual processing steps (steps 302-322) for fabricating donor molecules according to aspects of the present disclosure.

Initially, a clean silicon (Si) $2\times1$ surface is formed in an ultra-high-vacuum (UHV) by heating to near the melting point. This surface has a $2\times1$ unit cell and consists of rows of σ-bonded silicon dimers with the remaining dangling bond on each silicon atom forming a weak π-bond with the other silicon atom of the dimer of which it comprises.

Method 300 commences at step 302 (i.e., monohydride deposition), where the clean Si 2x1 surface is exposed to atomic hydrogen $H$ to break the weak silicon π-bonds, allowing H atoms to bond to the silicon dangling bonds. Under controlled conditions, a monolayer of H can be formed with one H atom bonded to each Si atom, satisfying the reactive dangling bonds, effectively passivating the surface.

Next, at step 304 (i.e., hydrogen desorption), an STM tip is used to selectively desorb H atoms from the passivated surface by the application of appropriate voltages and tunnelling currents, forming a pattern in the H resist.

It will be appreciated that H atoms are desorbed from precise locations where donor dot sites are to be placed. For example, if the donor molecule 202 is to include two donor atom sites that have a spacing of anywhere between 3-9 nanometers, the H atoms are desorbed in such a manner as to create two lithographic patches that are 3-9 nanometers apart. Further, the size of the lithographic patches created by the hydrogen desorption may depend on the number of donor atoms that are required to be placed in each of the donor dot sites. In one example, if 1 donor atom is to be positioned in one of the patches and two donor atoms are to be positioned in the other patch, the STM tip may be utilized to desorb 6 hydrogen atoms in a first location to create a first patch and 15 hydrogen atoms may be desorbed in a second location 3-9 nanometers apart to create a second larger patch. Similarly, if larger number of donor atoms are to be placed in the patches, more hydrogen atoms can be desorbed to create lithographic patches of larger sizes. In other examples, the sizes of the patches may be smaller or larger than those described in the example above. Further still, in some examples, machine learning techniques may be utilized to control the number of donor atoms placed in any lithographic patch.

This process is repeated to create positions for other donor atom sites if the molecule 202 includes addition donor dots. Otherwise, the process may be repeated to create positions for other donor-molecules 202. In this way, regions of bare, reactive Si atoms are exposed along dimer rows, allowing the subsequent adsorption of reactive species directly to the Si surface.

Returning to Fig. 3A, at step 306 (i.e., $PH_3$ dos-

ing), phosphine (PH3) gas is introduced into the vacuum system via a controlled leak valve connected to a specially designed phosphine micro-dosing system. The phosphine molecule bonds strongly to the exposed Si surface, through the holes in the hydrogen resist. As noted previously, at a particular donor site, a phosphine molecule may bond with any one of the exposed silicon dimers.

Subsequent heating of the STM patterned surface for crystal growth causes the dissociation of the phosphine molecules and results in the incorporation of P into the first layer of Si at step 308. It is therefore exposure of an STM patterned H passivated surface to $PH_3$ that produces the required donor molecules 202.

The hydrogen may then be desorbed, at step 310, before overgrowing the surface with silicon at room temperature, at step 312. An alternative to step 312 is to grow the silicon directly through the hydrogen layer, as shown in step 314.

At step 316, the surface is rapidly annealed.

Silicon is then grown on the surface at elevated temperature, shown in step 318. In one example, approximately $50 \pm 10$ nm of epitaxial silicon is grown at a temperature of 250°C. In some cases, a barrier, also known as a locking layer, may be grown as shown in step 320. Finally, conductive gates 211 and a microwave antenna 214 may be aligned on the surface, as shown in step 322 using electron beam lithography. Using registration markers, such as evaporated metal markers, the antenna 214 may be aligned at a lateral distance of $300 \pm 50$ nm from the buried donor molecules to produce an oscillating magnetic field B1 perpendicular to the substrate at the donors' position.

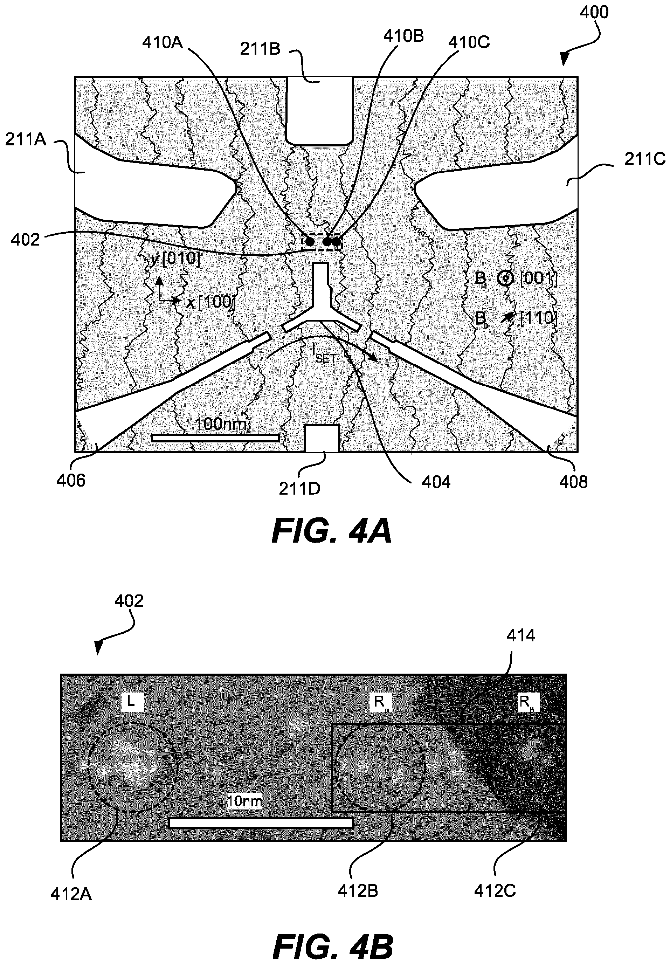

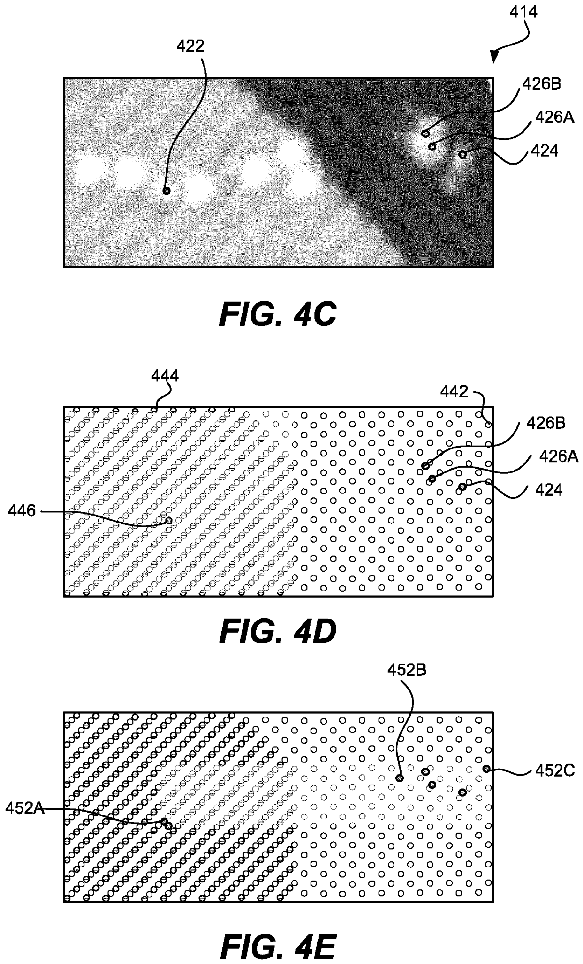

Fig 4 shows the atomic arrangement of a 1P-2P donor molecule 200 according to aspects of the present disclosure. In this case, the module 200 includes 1 donor dot on the left marked as L and two donor dots to the right, marked as $R_a$ and $R_b$.

Fig. 4A shows, for example, an STM image 400 of the device after STM lithography. Bright regions are exposed silicon, which are subsequently dosed with phosphine, $PH_3$, to form conductive leads. The location of three donor dots 208 is indicated with a dashed rectangle 402.

Control structures, 211A, 211B, 211C, 211D shown in the bright regions, become electronically active upon dosing with phosphine and incorporation of P atoms into Si crystal lattice. The device 200 consists of four electrostatic gates (left 211A, middle 211B, right 211C and the SET gate 211D), a single electron transistor (SET) charge sensor 404 is tunnel coupled to the source 406 and the drain 408, and the three donor dots 410A, 410B and 410C marked with white circles. During operation, bias voltages $V_L$, Vc, $V_R$, $V_B$ applied to the gates 211 provide electrostatic control over the charge state, and the SET 404, which may be biased at $V_{SET} \approx 300$ $\mu V$, permits single-shot charge detection by monitoring the drain current $I_{SET}$. The SET can also act as an electron reservoir for the donor sites. In one example, the SET 404 is located at a distance of 18.5 nm from the donor molecule 200.

The central device region, indicated with the dashed rectangle 402, is enlarged in Fig. 4B and shows three lithographic patches 412A, 412B, and 412C and donor incorporation sites 208 after phosphine dosing - L, $R_\alpha$ and $R_\beta$.

In particular, a single lithographic opening 412A is defined on the left-hand side of the STM image in Fig. 4B, determining the position of a left donor dot, L. On the right-hand side, the two lithographic openings 412B, 412C can be distinguished, which are the incorporation sites for a pair of donor dots - $R_\alpha$ and $R_\beta$ After the STM images in Figs. 4A-B were taken, the sample was exposed to a high temperature (e.g., 250°C) to anneal the surface, followed by encapsulation with ~ 60 nm of epitaxial silicon. To conclude, from the analysis of the height profiles of the STM images, it is identified that 1P and 2P are incorporated within the two sites, $R\alpha$ and $R\beta$, respectively.

Collectively, these two sites $R_\alpha$ and $R_\beta$, separated by 8 nm, form a 1P-2P molecular state, which can bind up to five electrons. Importantly, the separation between the two donor sites (8 nm) is larger than the Bohr radius of the donor-bound electrons (typically < 3 nm).

Fig. 4C shows a close-up STM image showing the two dots, $R_\alpha$ and $R_\beta$, that form a molecule (the area indicated with the rectangle 414 in Fig. 4B). The coloured markers highlight the positions of important atomic features; the ejected silicon atom is indicated with the marker 422, the PH species is indicated with the marker 424 and the $PH_2$ with the markers 426A, 426B. Site $R_\alpha$ where we observe a single ejected silicon 422 is certain to yield a 1P upon the incorporation anneal, since the P donor atom is already incorporated into the Si surface at this point. Site $R_\beta$ is most likely to facilitate the incorporation of two P atoms from both PH species 424 and 426.

Fig. 4D is a schematic showing arrangement of the surface features in the device 200 with respect to the silicon lattice. The coloured markers indicate the silicon atoms within the device, where three consecutive atomic layers are marked with different shades. The white dots 442 indicate a first layer of silicon atoms, the dots with a single line 444 indicate a second layer of silicon atoms, and the dots with two lines 446 indicate a third layer of silicon atoms.

Fig. 4E is the same as in Fig. 4D but after incorporation of P atoms, showing final locations of donor atoms (markers 452A, 452B, and 452C) for the 1P-2P donor molecule 200. The atomic arrangement shown was determined using atomistic modelling of electron wavefunctions.

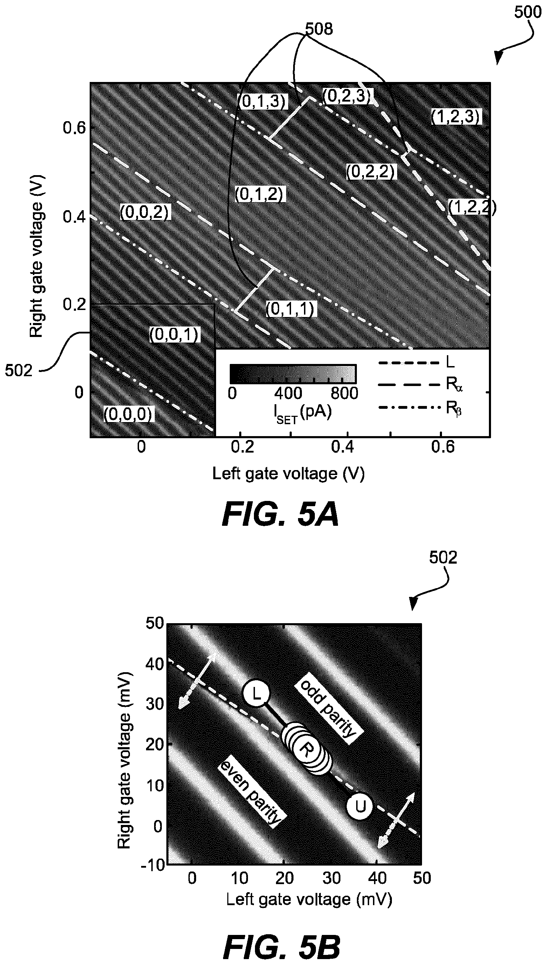

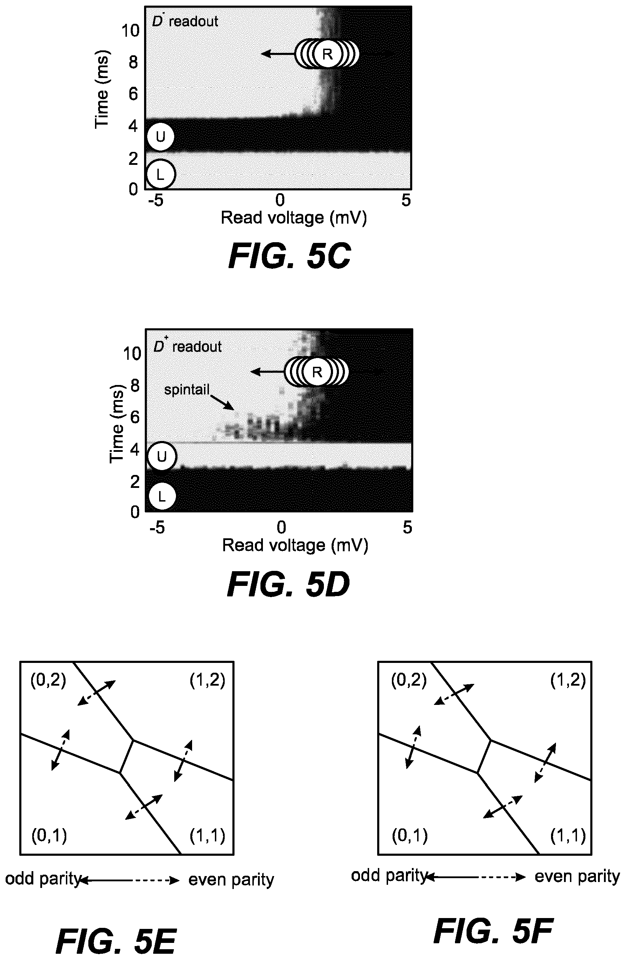

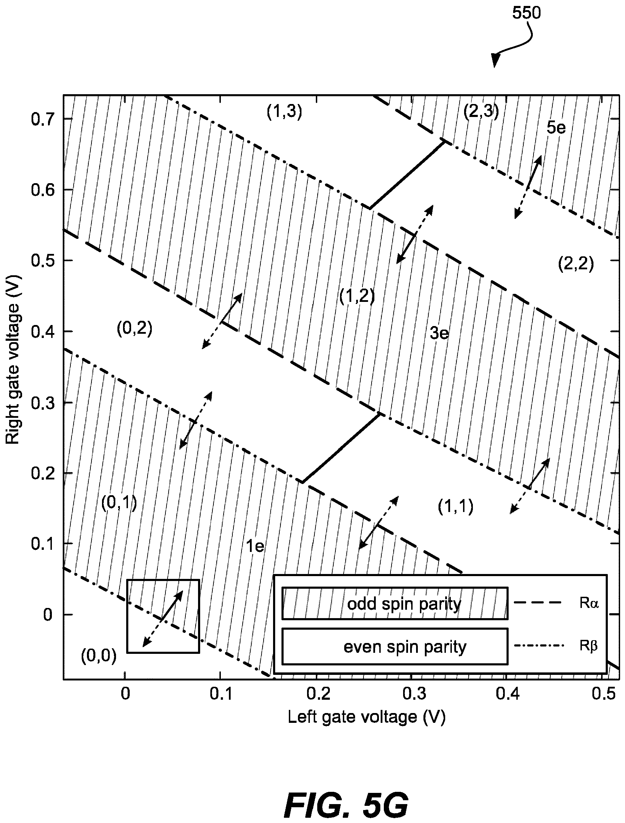

Fig 5 shows the exchange coupling $J$ between the right donor dots 1P ($R_\alpha$) and 2P ($R_\beta$) donor dots revealed via spin parity measurements.

In particular, Fig. 5A shows a charge stability diagram 500 of the device (shown in Fig. 4A) including three donor dots. The charge stability diagram 500 was obtained by varying voltages on the right and left gates 211A, 211C shown in Fig. 4A, and recording the resulting SET current, $I_{SET}$.

In this measurement, a fixed voltage of 750 mV is applied to the middle gate and a fixed voltage of 300 mV is applied on the SET gate. The diagonal dark lines in Fig. 5A correspond to the voltage settings for which the SET is in the Coulomb blockade, yielding low current $I_{SET}$. The diagonal bright lines correspond to the voltage settings for which the SET is out of the Coulomb blockade, yielding high current $I_{SET}$. The discontinuities in the periodic Coulomb SET lines represent charge transitions of donor dots, arising when an electron is added (or subtracted) to the site of a donor dot. The change in the charge occupation on the donor dot shifts the electrochemical potential of the SET 404, resulting in a change of the SET current, $I_{SET}$. Based on the 3 different slopes of these different charge transition lines, the charge transitions can be identified that correspond to the three different donor dots, as indicated with the white dashed lines in Fig. 5A, with the L transitions marked by the short dashed white lines 502, $R_{\alpha}$ transitions marked by long dashed white lines 504 and $R_{\beta}$ transitions marked by dot-dashed white lines 506.

The bottom-left corner of the charge stability diagram 510 corresponds to all donor dots being ionised, with no donor dot transitions observed below (at negative voltages). Within the achievable gate range, 6 electron charge transitions are identified, meaning that the upper-right corner of the charge stability diagram 500 corresponds to 6 electrons residing within the three donor dots. Additionally, three inter-site transitions are observed, marked in solid lines 508 in Fig. 5A, which indicate the electrons tunnelling from one donor dot to another. For each region in the charge stability diagram 500, the charge occupation is indicated with the numbers in brackets, corresponding to the number of electrons residing on L, $R_{\alpha}$, and $R_{\beta}$, respectively.

Fig. 5B shows a close-up of the stability diagram 500 around the first charge transition of the donor molecule in the region 502 shown in Fig. 5A. Spin readout is performed on this charge transition to determine the spin parity - i.e., if there is an even or odd number of electrons on the molecule below and above the charge transition. Spin readout is performed along the detuning axis (solid line in Fig.5b) at voltages for which the SET Coulomb line crosses the charge transition. The relative energy between the donor dot energy levels and the Fermi level of the SET is controlled with gate voltages. The point marked as L indicates the gate voltages for which $|\downarrow\rangle$ and $|\uparrow\rangle$ energy states of the electron spin qubit are below the Fermi level of the SET and an electron is loaded onto a donor molecule. The point marked as U indicates the gate voltages for which $|\downarrow\rangle$ and $|\uparrow\rangle$ energy states of the electron spin qubit are above the Fermi level of the SET, and an electron is unloaded from a donor molecule. Finally, the readout point marked as R is swept along the detuning axis to find the position where the Fermi level of the SET is in-between the $|\downarrow\rangle$ and $|\uparrow\rangle$ energy states of the electron spin qubit, allowing for spin-to-charge conversion.

Figs. 5C and 5D show a comparison of $D^-$spin (Fig. 5C) and $D^+$spin (Fig. 5D) readout at the first charge transition to determine the spin parity shown in Fig. 5B. Depending on the number of electrons that reside on the donor dot, the spin readout is either $D^+$ type for an even→odd number of electrons on the molecule or $D^-$ type for odd-even. For the $D^+$ readout, the spin signature is observed for an electron filling an unoccupied energy level of the donor molecule, while in the $D^-$ readout the spin of an electron is measured by loading a complimentary electron to form a two-electron singlet state on the donor molecule. Fig. 5C shows an attempted $D^-$ spin readout with the pulse sequence L-U-R, denoting the electron loaded on a donor dot then unloaded, and read-out. Fig. 5D shows $D^+$ readout with a pulse sequence U-L-R.

Here it is observed that there is no spin signature for $D^-$ readout, while a characteristic 'spin-tail' is observed for $D^+$, indicating that there is an even electron number below the transition and odd above it.

Fig. 5E shows a schematic of the charge stability diagram showing odd (solid arrows) and even (dashed arrows) spin pairing for a weakly coupled pair of donor dots (e.g., in the weak coupling regime shown in Fig. 1). Fig. 5F shows a schematic of the charge stability diagram showing odd (solid arrows) and even (dashed arrows) spin pairing for a strongly coupled pair of donor dots (e.g., in the strong coupling regime shown in Fig. 1). When the electrons are isolated (weak-coupling regime), the parity follows the number of electrons on each dot. However, in the strong-coupling regime, the electrons are shared between the dots; hence, the parity follows the sum of electrons on both dots.

Fig. 5G is a schematic charge stability diagram 550 showing the charge transitions for $R_{\alpha}$ and $R_{\beta}$ and the measured electron parity at each transition. From the spin pairing observed, it can be concluded that the two dots $R_{\alpha}$ and $R_{\beta}$ are strongly coupled. The red-shaded regions correspond to three separate charge regions of odd parity (1e, 3e and 5e) occupying the $R_{\alpha}$-$R_{\beta}$ molecule where spin readout may be performed.

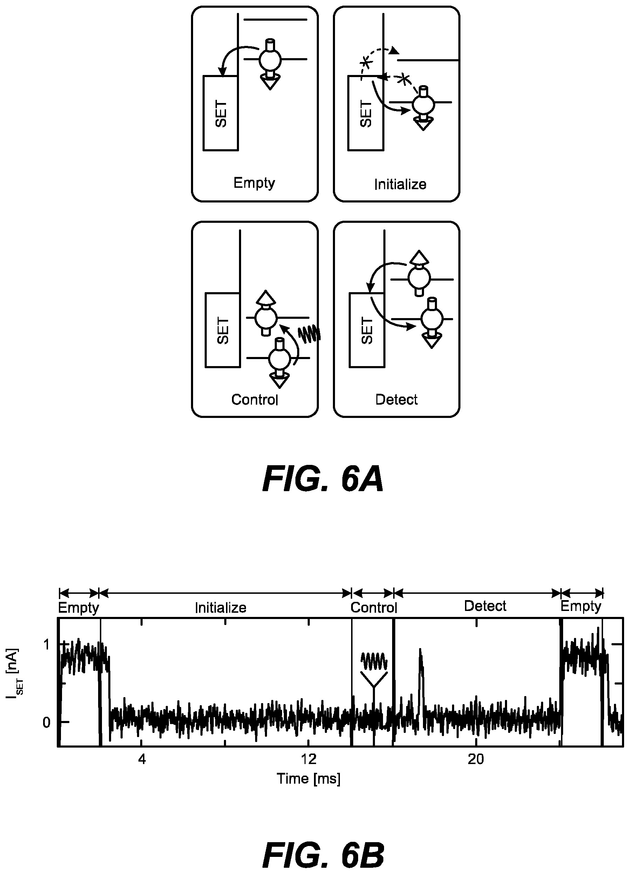

In some examples, coherent control of the donor molecule 200 is achieved by varying the pulse duration for fixed microwave power and frequency and extracting the spin-up fraction using a single-shot spin readout method. The single-shot readout method includes a four-level pulse sequence based on controlled tunnelling to and from the SET. Fig. 6A schematically illustrates this method, while Fig. 6B shows an example readout trace of the SET current as a function of time, for the representative four-stage pulse sequence of Fig. 6A. In particular, as seen in box 602 in Fig. 6A, the first stage includes emptying the spin state, leaving the molecule in a spin 0, even parity charge state (four electrons total). In the second stage (initialize), shown in box 604, an odd parity electron is loaded deterministically in the spin down state by aligning the SET Fermi energy between the two Zeeman split spin states to initialize the spin. This state is then isolated from the SET 404 by electrostatically plunging it far below the Fermi energy during the application of an ESR control pulse via the microwave antenna in the third stage (control), shown in box 606. Finally, in the fourth stage (detect), shown in box 608, the Zeeman split state is brought near the system's Fermi energy, producing a detectable change in $I_{SET}$ depending on the spin state. Each full sequence may take about 24 ms, limited by the electron tunnel rate (~3 kHz) to and from the SET. Statistics of the fraction of spin-up outcomes $p\uparrow$ can be obtained by repeating this pulse sequence.

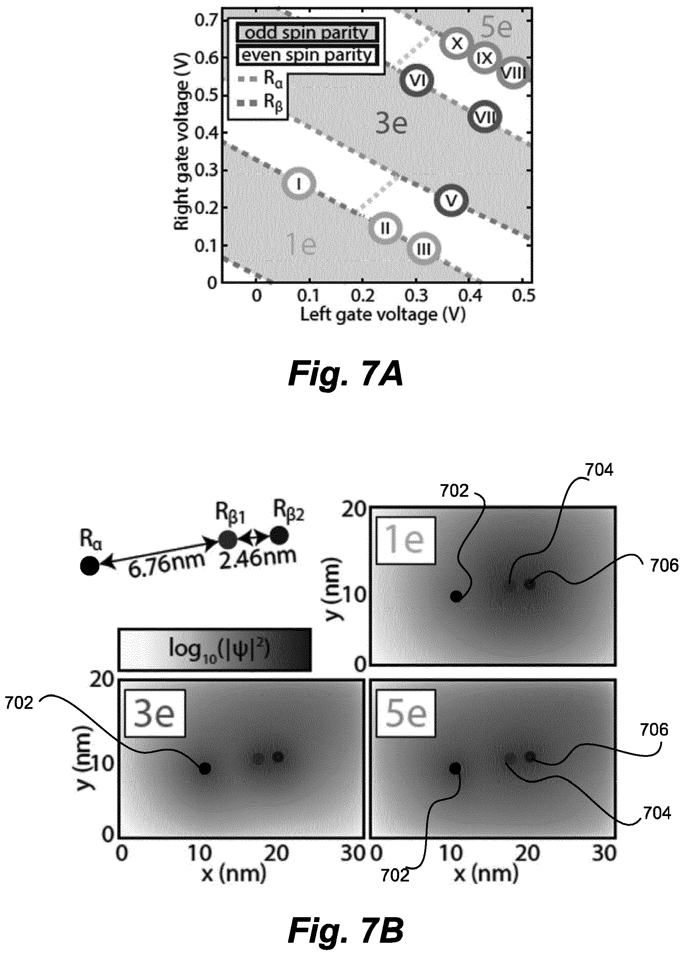

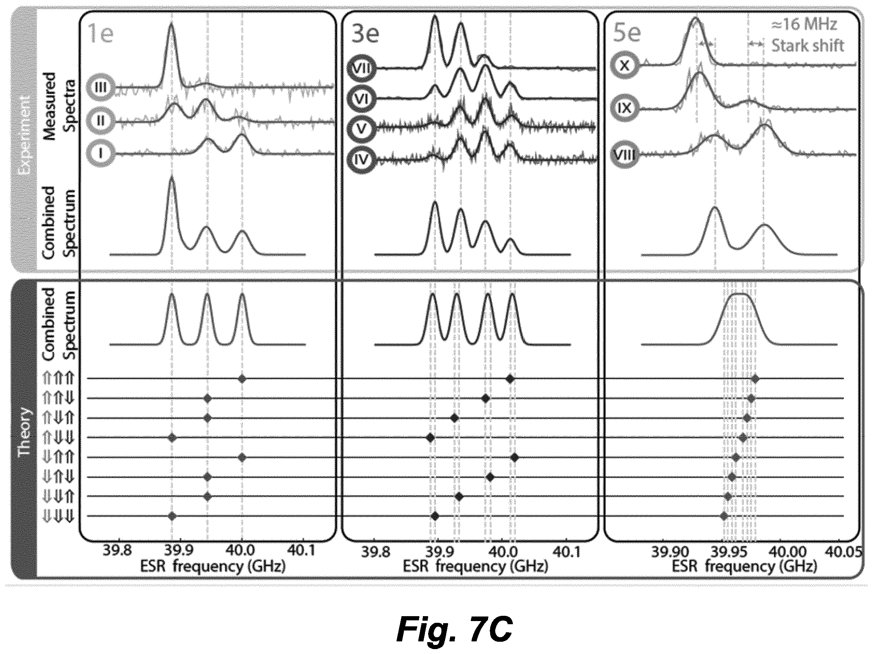

Fig. 7 illustrates the ESR spectra of 1, 3, and 5 electrons bound to a 1P-2P donor molecule as disclosed herein. In particular, Fig. 7A shows a charge stability diagram of a 1P-2P donor molecule showing the charge transitions for $R_\alpha$ and $R_\beta$ and the measured electron parity at each transition and the positions of ESR spectra of the first, third and fifth electrons bound to the 1P-2P donor molecule. In particular, I-III indicate positions of ESR spectra of the first electron, V-VII indicate positions of ESR spectra of the second electron, and VIII-X indicate positions of ESR spectra of the fifth electron.

Fig. 7B shows tight binding modelling of 1e, 3e, and 5e electron wavefunctions bound to a 1P-2P molecule. For each case, the density of electron wave-function, $|\psi|^2$ is calculated as a function of x and y coordinates and plotted as $\log_{10}(|\psi|^2)$. In the modelling, electric field of Ey = -4 MV/m (1e, 3e, 5e) and Ex = -1.5 MV/m (1e), Ex = -1.8 MV/m (3e), Ex = -2 MV/m (5e) is used to approximate the electric field present in the device. The three P atoms, $A_{R\alpha}$, $A_{R\beta1}$, $A_{R\beta2}$, are indicated with markers 702, 704, and 706, respectively in this diagram. Further, the distance between the 1P and 2P donors is considered to be 6.76nm and the distance between the donors $R_{\beta1}$ and $R_{\beta2}$ is 2.46nm.

Fig. 7C depicts the experimental ESR spectra 'Experiment' of the first (1e, left), third (3e, middle) and fifth (5e, right) electrons bound to the 1P-2P molecule. The measured spectra represent the probability of measuring a spin-up state plotted as a function of the frequency of the ESR pulse applied prior to the spin measurement. The ESR spectra marked I-X correspond to the readout points marked in Fig. 7A. The individual spectra for each electron occupation are vertically off-set for clarity. The resonant frequencies are consistent between the readout points for 1e and 3e, while a Stark shift up to 16 MHz is observed for 5e upon changing the readout position from VIII to X. The resonant energies can be clearly distinguished in the combined spectrum, where the maximum value recorded for each ESR frequency for a given electron number is plotted.

Fig. 7C also shows the theoretical ESR spectra 'Theory' calculated based on the wavefunction calculations shown in Fig. 7B. The resonant energies corresponding to 8 different nuclear spin configurations of atoms $A_{R\alpha}$, $A_{R\beta1}$, $A_{R\beta2}$ are plotted with diamond markers. The theoretical spectra are obtained by generating a Gaussian peak with $\sigma$ = 7MHz for each of the possible resonances. For 1e and 3e cases, an excellent correlation is detected between experimental and theoretical spectra. For the 5e case, the total hyperfine coupling of 27.4 MHz is determined from the tight-binding modelling, while a slightly larger hyperfine of 42 MHz is observed in the experiment.

The methods and systems are described with reference to a 1P-2P system. It will be appreciated that this is merely an example device and that the methods and systems can be used with other number of donor dot based donor molecules without departing from the scope of the present disclosure. Further, instead of donor atoms, the molecule described above may be formed of other dopant atoms such as acceptor atoms where the spin qubits are formed from unpaired holes in the quantum dots.

The term "comprising" (and its grammatical variations) as used herein are used in the inclusive sense of "having" or "including" and not in the sense of "consisting only of".

It will be appreciated by persons skilled in the art that numerous variations and/or modifications may be made to the invention as shown in the specific embodiments without departing from the spirit or scope of the invention as broadly described. The present embodiments are, therefore, to be considered in all respects as illustrative and not restrictive.

## Claims

1. A quantum processing element comprising:

   a semiconductor substrate;
   a dielectric material forming an interface with the semiconductor substrate; and
   a donor molecule comprising a plurality of dopant dots embedded in the semiconductor substrate, each dopant dot comprising one or more dopant atoms and one or more electrons/holes confined to the dopant dots, where a distance between the dopant dots is between 3 and 9 nanometres.

2. The quantum processing element of claim 1, comprising two dopant dots, wherein a first dopant dot comprises two dopant atoms and a second dopant dot comprises one dopant atom.

3. The quantum processing element of any one of claims 1-2, wherein the dopant atoms are phosphorus atoms.

4. The quantum processing element of any one of claims 1-3, wherein quantum information is encoded in a spin of an unpaired electron/hole of the one or more electrons/holes.

5. The quantum processing element of claim 4, wherein the spin of the unpaired electron/hole is controlled with an external magnetic and/or electric field.

6. The quantum processing element of claim 5, wherein the electric field is applied at a predetermined angle to a central axis of the dopant dots.

7. The quantum processing element of any one of claims 1-6, wherein spin of an electron/hole confined to one of the dopant dots is strongly exchange coupled to an electron/hole confined to a neighbouring dopant dot of the plurality of dopant dots.

8. The quantum processing element of claims 7, wherein due to the strong exchange coupling, the spins of the exchange coupled electrons/holes form magnetic singlet states across the donor molecule.

9. The quantum processing element of any one of claims 1-6, wherein an external magnetic field is applied to separate energy levels of at least one spin of the one or more electrons/holes, and where a resultant Zeeman splitting is smaller than an exchange coupling between the dopant dots.

10. The quantum processing element of any one of claims 1-9, wherein selective control of a spin of an electron/hole of the one or more electrons/holes is achieved due to presence of a plurality of dopant dots, such that a spin splitting of the electron/hole is dependent on contributions of hyperfine coupling between the electron/hole spin and each spin of the one or more dopant atoms.

11. A quantum processing system, comprising:

a semiconductor substrate;
a dielectric material forming an interface with the semiconductor substrate; and
a plurality of donor molecules embedded in a plane in the semiconductor substrate, where each donor molecule includes a plurality of dopant dots, each dopant dot includes one or more dopant atoms and one or more electrons/holes confined to the dopant dots, where a distance between adjacent dopant dots in a donor molecule is between 3 and 9 nanometres.

12. A method of fabricating an engineered quantum processing element, the method comprising:

exposing a semiconductor substrate to atomic hydrogen to form a monolayer of hydrogen and passivating a surface of the semiconductor substrate;
selectively desorbing hydrogen atoms from the passivated surface by application of appropriate voltages and tunnelling currents to an STM tip, and forming a plurality of patches in the hydrogen monolayer, wherein a distance between adjacent patches is between 3 and 9 nanometres; and
incorporating one or more donor atoms in each of the plurality of patches in the hydrogen monolayer, to form a donor molecule.

13. The method of claim 12, further comprising:

desorbing the hydrogen monolayer;
overgrowing a surface with a layer of the semiconductor;
growing a dielectric layer above the layer of the semiconductor; and
depositing one or more gates above positions of the donor atoms.

14. The method of any one of claims 12-13, wherein a first patch and a second patch are formed in the hydrogen monolayer, and a single donor atom is incorporated in the first patch and two donor atoms are incorporated in the second patch to form the donor molecule.

15. The method of any one of claims 12-14, wherein sizes of the plurality of patches is based on a number of donor atoms to be incorporated in corresponding patches.

FIG. 1A

FIG. 1B

**Fig. 2**

**Fig. 3A**

300

312

From Fig. 3A

314

316

318

320

322

**Fig. 3B**

**FIG. 4A**

**FIG. 4B**

**FIG. 4C**

**FIG. 4D**

**FIG. 4E**

**FIG. 5A**

**FIG. 5B**

**FIG. 5C**

**FIG. 5D**

odd parity ←----→ even parity

**FIG. 5E**

odd parity ←----→ even parity

**FIG. 5F**

**FIG. 5G**

**FIG. 6A**

**FIG. 6B**

**Fig. 7A**

**Fig. 7B**

*Fig. 7C*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- AU 2022900615

- AU 2022203834